(19) Europäisches Patentamt

European Patent Office

Office européen des brevets

(11) EP 0 458 645 B1

(12) **EUROPEAN PATENT SPECIFICATION**

(45) Date of publication and mention
of the grant of the patent:
**25.09.1996 Bulletin 1996/39**

(51) Int Cl.⁶: **H04B 1/66**

(21) Application number: **91304699.1**

(22) Date of filing: **23.05.1991**

(54) **Subband digital signal encoding apparatus**

Digitales Teilbandsignalkodiergerät

Dispositif de codage numérique d'un signal par sous-bandes

(84) Designated Contracting States:
**AT DE FR GB IT NL**

(30) Priority: **25.05.1990 JP 133980/90**

(43) Date of publication of application:
**27.11.1991 Bulletin 1991/48**

(73) Proprietor: **SONY CORPORATION**
**Tokyo 141 (JP)**

(72) Inventors:
- **Akagiri, Kenzo, c/o Patents Div.**
  **Shinagawa-ku, Tokyo 141 (JP)**
- **Tsutsui, Kyoya, c/o Patents Div.**
  **Shinagawa-ku, Tokyo 141 (JP)**
- **Fujiwara, Yoshihito, c/o Patents Div.**
  **Shinagawa-ku, Tokyo 141 (JP)**

(74) Representative: **Cotter, Ivan John et al**
**D. YOUNG & CO.**
**21 New Fetter Lane**
**London EC4A 1DA (GB)**

(56) References cited:
**WO-A-88/04117**

- **RUNDFUNKTECHNISCHE MITTEILUNGEN. vol. 33, no. 4, August 1989, NORDERSTEDT DE pages 149 - 154,VAUPEL:'Transformationscodierung für qualitativ hochwertige Audiosignale mit Signalvor- und -nachverarbeitung im Zeitbereich'**
- **BELL SYSTEM TECHNICAL JOURNAL. vol. 56, no. 5, May 1977, NEW YORK US pages 747 - 769,CROCHIERE:'On the Design of Sub-band Coders for Low-Bit-Rate Speech Communication'**

## Description

This invention relates to digital signal encoding apparatus.

For high efficiency encoding of audio or voice signals, there is known an encoding technique by adaptive bit allocation in which the input signals, such as audio or voice signals, are divided on the time axis or on the frequency axis into a plurality of channels, and the numbers of bits are adaptively allocated for the respective channels. Among the encoding techniques of the audio signals by adaptive bit allocation, there are a sub-band coding (SBC), in which the audio signals on the time axis are divided into a plurality of frequency bands for encoding, an adaptive transform coding (ATC) in which signals on the time axis are converted into those on the frequency axis by orthogonal transform and divided into a plurality of frequency bands in each of which adaptive signal encoding is performed, and a so-called adaptive bit coding (APC-AB), in which the sub-band encoding and adaptive transform encoding are combined such that the signals on the time axis are divided into frequency bands and the signals of the respective bands are converted into baseband signals and predictively encoded by nth order linear predictive analyses, where n is an integer equal to two or more.

In the field of high efficiency encoding, techniques of high efficiency encoding, in which so-called masking characteristics of the human auditory sense is taken into account, have been adopted extensively. The masking effect means a phenomenon in which a signal is masked by another signal and thereby becomes inaudible. This masking effect is classified into that on the audio signals on the time axis and that on the signals on the frequency axis.

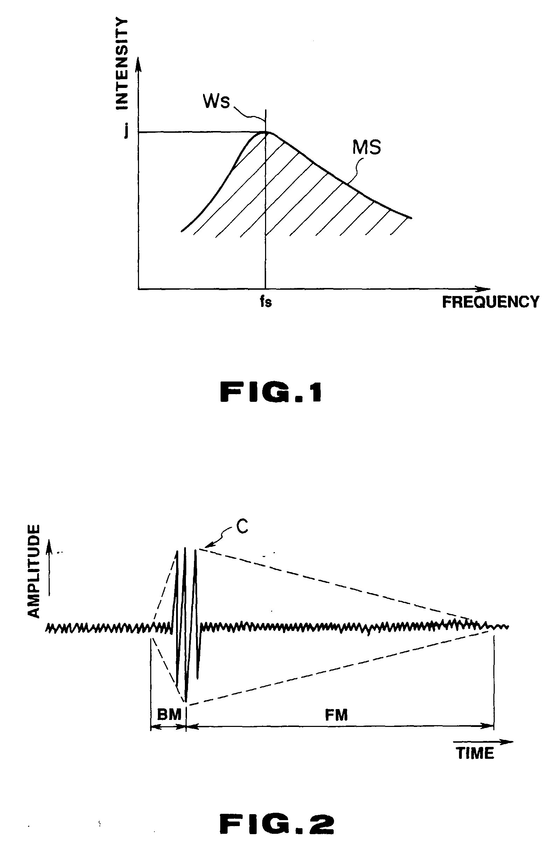

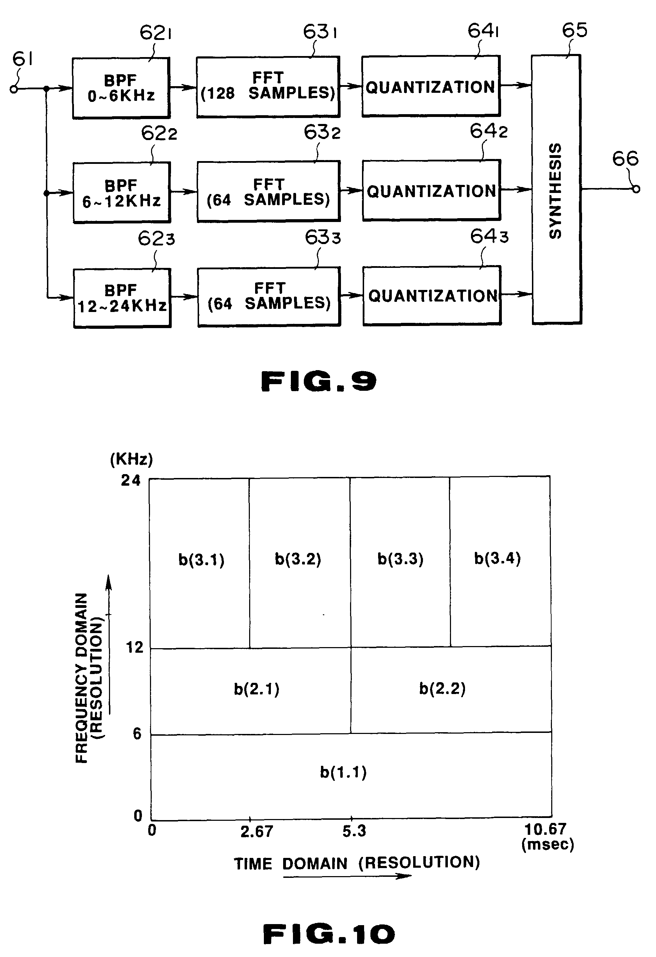

The masking effect on the audio signals on the frequency axis will now be explained. In the case of a sine wave $W_S$ having a frequency $f_s$, the masking spectrum or masking curve MS, representing the masking effect by the human auditory sense, is as shown in Figure 1. By this masking spectrum MS, an area indicated by hatched lines is masked. Thus the noise within the masking spectrum MS, if any, becomes inaudible, so that, with the actual audio signal, any noise within the masking spectrum MS is allowable. Thus the allowable noise level in the case of the sine wave $W_S$ is below the level shown at j in Figure 9. Also the masking effect is maximum at the frequency $f_s$ of the sine wave $W_S$ and becomes lower the more the frequency is removed from the frequency $f_s$ of the sine wave $W_S$.

The masking on the audio signals on the time axis is classified into temporal masking and concurrent masking. Concurrent masking means the effect in which a smaller sound (or noise) generated simultaneously with a larger sound is masked by the larger sound and becomes inaudible. Temporal masking means an effect in which, as shown in Figure 2, the smaller sound or noise temporally before and after a larger sound (a high level signal part C in the figure) is masked by the larger sound and becomes inaudible. With temporal masking, masking of the sound temporally after the larger sound is termed forward masking and masking of the sound temporally before the larger sound is termed backward masking. In temporal masking, the effect of forward masking FM in Figure 2 persists for a long time (about 100 msec, for example), while that of backward masking BM has a shorter duration (about 5 msec, for example), on account of the characteristics of the human auditory sense. The masking level or masking quantity is about 20 dB and 30 dB with forward masking and backward masking, respectively.

With the above described high efficiency encoding, it is desired to achieve further increase in the bit compression rate L or the amount of bit reduction. However, with the high efficiency encoding, in which bit compression is achieved by taking advantage of the above described masking effect, only one of the masking effect on the signals on the frequency axis or the masking effect on those on the time axis is taken into account, that is, it has not been tried to take both masking effects into account, simultaneously.

International (PCT) Patent Application Publication No. WO 88/04117, published 2 June 1988 (which corresponds to US Patent No US-A-4 972 484, published 20 November 1990), discloses apparatus for transmitting or storing a digitised audio signal in which a bank of quadrature mirror filters is used to divide the digital audio signal into a plurality of frequency band signals (sub-bands). The quantising of the sample values in the sub-bands is controlled such that the quantising noise levels of the individual sub-band signals are at approximately the same level difference from the masking level of the human auditory system resulting from the individual sub-band signals.

Funktechnische Mitteilungen, vol. 33, no. 4, August 1989, pages 149-154, "TRANSFORMATIONCODIER-UNG FUER QUALITATIV HOCHWERTIGE AUDIOSIG-NALE MIT SIGNALVOR- UND-NACHUERARBEITUNG IM ZEITBEREICH (Transformation coding of high-quality audio signals with temporal pre- and post- processing)", Thomas Vaupel, discloses apparatus for encoding a digital audio signal. The apparatus includes an MSC-coder in which the digital signal is segmented into blocks and subjected to Fourier transformation coding. In order to enhance the signal to noise ratio of the apparatus, a transition in a transformation block is detected and, in response thereto, the power of the signal is emphasised, prior to the transition, before the transformation coding is carried out. The emphasis factor is calculated from the mean signal powers prior to and after the transition. The power of the signal is then de-emphasised, after the coding operation, at the receiver.

According to the present invention there is provided a digital signal encoding apparatus for encoding an input digital signal, the apparatus comprising:

dividing means supplied with said input digital signal for dividing the frequency range of said input digital signal into a plurality of frequency bands;
first noise level setting means for setting a first allowable noise level of each frequency band based on the energy of each frequency band;
second noise level setting means for setting a second allowable noise level of each frequency band based on the energies of signals in the temporally adjacent corresponding frequency band;
combining means for combining said first and second allowable noise levels, for generating a combined allowable noise level; and

quantizing means for quantizing signal components of each frequency band with a number of bits depending upon said combined allowable noise level.

Thus an embodiment of the present invention provides a digital signal encoding apparatus for encoding an input digital signal comprising dividing means to which said input digital signal is supplied, said dividing means dividing the frequency range of said input digital signal into a plurality of frequency bands, first noise level setting means for setting a first allowable noise level of each frequency band based on the energy of each frequency band, second noise level setting means for setting a second allowable noise level of each frequency band based on the energies of the signals temporally adjacent to the signals of the frequency band under consideration for quantization, combining means for combining said first and second allowable noise levels, and means for quantizing signal components of each frequency band with a number of bits corresponding to the level of the difference between the energy of each frequency band and the output of said combining means.

In an embodiment of the present invention, an allowable noise level which takes into account the masking on the frequency axis is set by first noise level setting means for the signal of the frequency band under consideration for quantization, while another allowable noise level which takes into account the masking on the signals temporally adjacent to the signals of the frequency band under consideration is set by second noise level setting means for the same signal of the frequency band under consideration for quantization.

With such a digital signal encoding apparatus, the frequency range of the input digital signal is divided into a plurality of frequency bands so that the bandwidth is broader towards the side of the frequency bands of higher frequencies. The first allowable noise level is set from one frequency band to another on the basis of the energy of each frequency band while the second allowable noise level is set on the basis of the energies of the signals temporally adjacent to the signal of the band which is under consideration for quantization. The signal components of each frequency band are quantized with the number of bits corresponding to the level of the difference between the sum output of the first and second allowable noise levels and the energy of such frequency band. In this manner, both the masking effect for the signals of the frequency band under consideration on the frequency axis and the masking effect for the signals on the time axis may be utilized effectively for increasing the degree of bit reduction or lowering the bit rate while minimizing deterioration of the sound quality even though the number of bits is reduced.

The invention will now be described by way of example with reference to the accompanying drawings, throughout which like parts are referred to by like references, and in which:

Figure 1 is a chart showing the spectrum of audio signals;
Figure 2 is a chart for illustrating temporal masking;
Figure 3 is a block circuit diagram showing the construction of a digital signal encoding apparatus according to an embodiment of the present invention;
Figure 4 is a chart for illustrating critical bands;
Figure 5 is a chart for illustrating a bark spectrum;
Figure 6 is a circuit diagram showing a filter circuit;
Figure 7 is a chart for illustrating a masking spectrum;
Figure 8 is a chart for illustrating the synthesis of a minimum audibility curve and the masking spectrum;
Figure 9 is a block circuit diagram showing the construction of a modified embodiment; and
Figure 10 is a chart for illustrating the resolution of the frequency domain and the time domain.

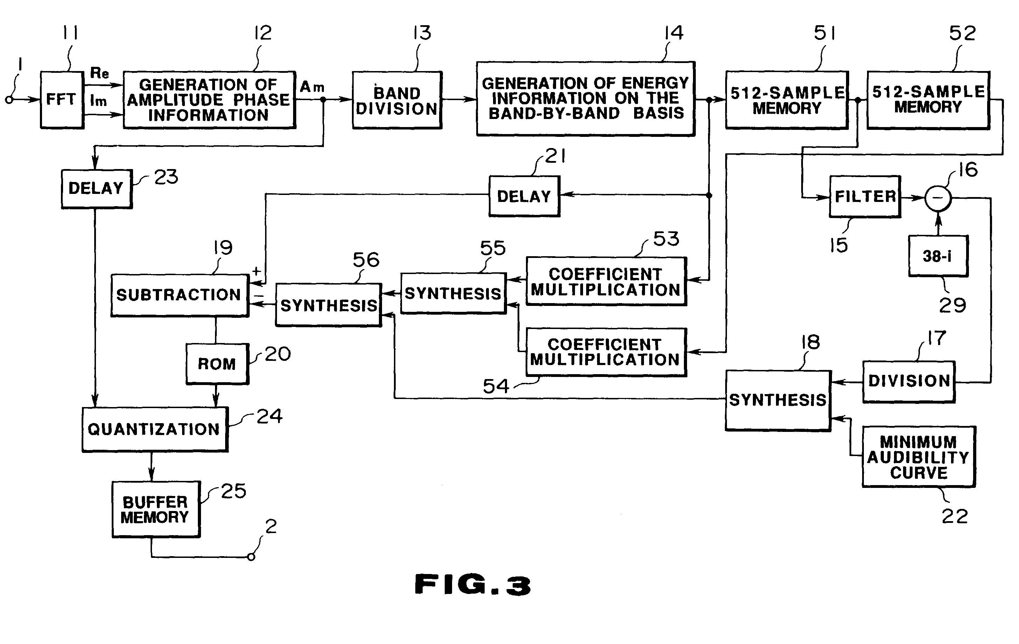

Referring to Figure 3, a digital signal encoding apparatus according to the present invention includes a band-dividing circuit 13, a sum detection circuit 14, a filter 15, a subtraction circuit 16, a division circuit 17 and a synthesizing circuit 18, operating conjointly as first noise level setting means for dividing the input digital signals into a plurality of frequency bands so that the bandwidth will be broader towards the side of the frequency bands of higher frequencies, and for setting a first allowable noise level on the band-by-band basis based on the energy of each band. The digital signal encoding apparatus also includes memories 51 and 52, coefficient multiplication units 53 and 54 and a synthesizing circuit 55, operating conjointly as second noise level setting means for setting a second allowable noise level based on the energies of signals temporally adjacent to the signals of a frequency under consideration for quantization. The signal encoding apparatus further includes a synthesizing (combining) circuit 56 as synthesizing means for synthesizing the allowable output noise levels of the first and second noise level setting means, and a quantization circuit 24 for quantizing signal components of each frequency band with the number of bits corresponding to the level of the difference between the energy of each frequency band and the output from the synthesizing circuit 56. Thus, with the present apparatus, the first allowable noise level which takes the masking on the frequency axis and a minimum audibility curve into account is set by the first noise level setting means for the signal of the frequency band under consideration for quantization, while the second allowable noise level which takes the temporal masking by signals temporally adjacent to the signals of the frequency band under consideration into account is set by the second noise level setting means for the same signal of the frequency band under consideration. The quantization output from the quantization circuit 24 is outputted via a buffer memory 25 at an output terminal 2.

In the present apparatus, an adaptive transform encoding (ATC) is employed, in which audio signals, for example, are processed by fast Fourrier transform (FFT) for converting the signals on the time axis into those on the frequency axis, and the resulting signals on the frequency axis are encoded, or re-quantized. More specifically, the audio signals, which are the signals on the time axis, are supplied to an input terminal 1 and thence transmitted to a FFT circuit 11. In the FFT circuit 11, the audio signals on the time axis are converted at a predetermined time interval, for example, at every 512 samples, into signals on the frequency axis, for producing FFT coefficients each consisting of a real number component Re and an imaginary number component Im. These FFT coefficients are transmitted to an amplitude phase information generation circuit 12, where an amplitude value Am and a phase value are produced from the real number component Re and the imaginary number component Im, with the information of the amplitude value Am being entered to the present apparatus as the input digital signal. It is noted that the human auditory sense in general is sensitive to the amplitude or power in the frequency domain, even although it is rather dull to the phase. With this in view, only the amplitude value Am is taken out from the output of the amplitude phase information generating circuit 12 as the above mentioned input digital signal.

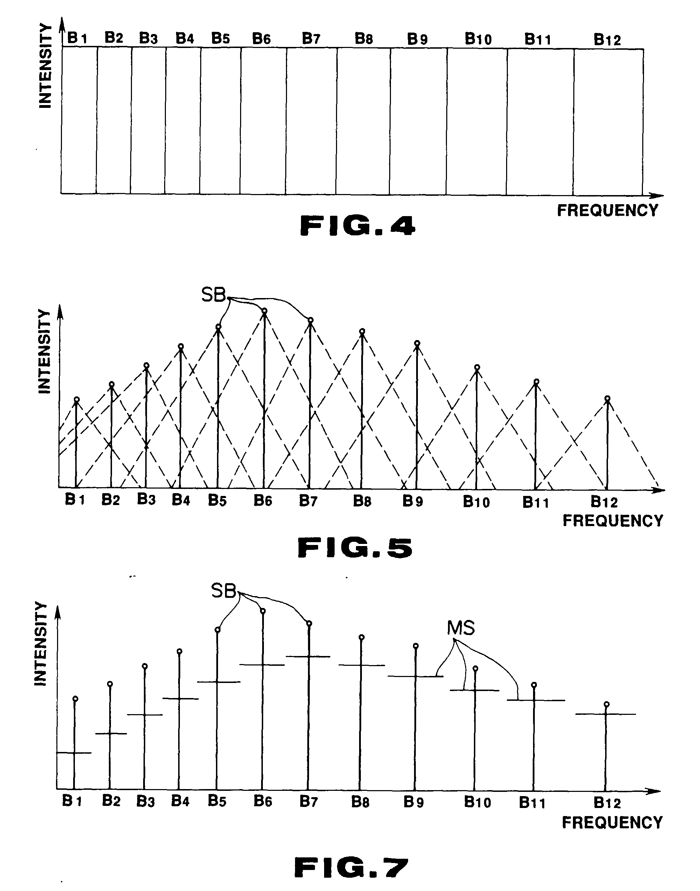

The input digital signal of the amplitude value Am thus produced is transmitted to the band-dividing circuit 13, where the input digital signal, expressed as the amplitude value Am, is divided into, for example, so-called critical bands. The critical bands take human auditory characteristics or frequency-analyzing capability into account. Thus the frequency range of 0 to 24 kHz is divided into 24 frequency bands so that the bandwidths of the bands will become broader in the direction of the higher frequency bands. It is noted that the human auditory sense has characteristics of a sort of bandpass filters, with the bands of the frequency range divided by the filters being termed the critical bands shown in Figure 4. In this figure, the number of the critical bands if twelve and the bands are terms $B_1$ to $B_{12}$.

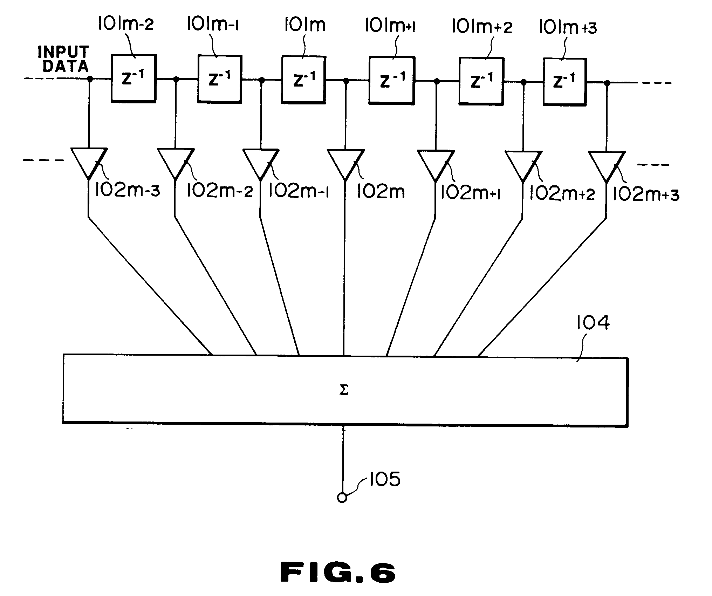

The amplitude values Am for the critical bands, such as 24 critical bands, obtained at the band-dividing circuit 13, are transmitted to the sum detection circuit 14, where the energies or spectral intensities of each band are found by taking the sum of the amplitude values in each band (the peak value or the mean value of the amplitude values Am or the energy sum in each band). The outputs of the sum detection circuit 14, that is the spectrum of the sums of the bands, are generally termed the bark spectrum, the values of which are shown for example in Figure 5.

For taking the effect of the bark spectrum on the masking into account, a predetermined weighting function is convolved on the bark spectrum (convolution). To this effect, the outputs of the sum detection circuit 14, that is the values of the bark spectrum SB, are transmitted to the filter circuit 15 by means of the memory 51, which reads and/or writes the outputs of the sum detection circuit 14 each consisting of, for example, 512 samples. The filter circuit 15 is constituted by delay ($Z^{-1}$) elements $101_{m-2}$ to $101_{m+3}$ for sequentially delaying the input data, multiplication units $102_{m-3}$ to $102_{m+3}$ for multiplying the outputs from the delay elements by filter coefficients (weighting functions), and a summation circuit 104. More specifically, the outputs of the delay elements are multiplied at the multiplication units $102_{m-3}$, to $102_{m+3}$ by, for example, filter coefficients 0.0000086, 0.0019, 0.15, 1, 0.4, 0.06 and 0.007, respectively, by way of performing a convolution of the bark spectrum SB. By this convolution, the sum of the effects from the adjacent values of the bark spectrum on the values of the bark spectrum under consideration, as shown by broken lines in Figure 5, is found as the outputs from the summation circuit 104, and the results of convolution is outputted at output terminal 105.

Meanwhile, if a level $\alpha$, corresponding to the first allowable noise level used for calculating the masking spectrum (allowable noise spectrum) of the bark spectrum SB, is low, the masking spectrum or masking curve with respect to signals on the frequency axis is also low, so that it becomes necessary to increase the number of bits allocated for quantization by quantization circuit 24. Conversely, if the level $\alpha$ is higher, the masking spectrum is increased, so that it becomes possible to reduce the number of bits allocated for quantization. It is noted that the level $\alpha$ is a noise level which will prove to be the above mentioned first allowable noise level for each critical band upon deconvolution which will be explained subsequently. In general, the spectrum intensities or energies of the audio signals are low in the higher frequency range. With this in mind, the level $\alpha$ is set so as to be higher towards the higher frequency range having the low energy values, for reducing the number of bits allocated for the higher frequency range. Thus, in the first noise level setting means, the level $\alpha$ is set as so to be higher for the same energy value for the critical bands of higher frequencies.

Thus the present apparatus calculates the level $\alpha$ corresponding to the first allowable noise level and controls the level $\alpha$ so as to be higher towards the side of the bands of higher frequencies. To this end, the output of the filter circuit 15 is supplied to the subtracter 16 for

finding the level $\alpha$ in the convolved region. The subtracter 16 is supplied with a permission function (a function expressing the masking level) for finding the level $\alpha$. The level $\alpha$ is controlled by increasing or decreasing the permission function, which is supplied from a function generating circuit 29.

The level $\alpha$ corresponding to the allowable noise level may be found from:

$$\alpha = S - (n - ai) \qquad (1)$$

where i is the number given to the critical bands in the order of increasing frequencies.

In formula (1), n and a are constants, with a>O, S is the intensity of the bark spectrum following convolution and (n-ai) in formula (1) becomes the permission function. Since it is more advantageous to decrease the number of bits from the higher range with lesser energy amounts for the sake of decreasing the number of bits on the whole, as discussed above, the values n and a are set so that n=38 and a=1 in the present embodiment, whereby satisfactory encoding can be achieved without deterioration in the sound quality.

The level $\alpha$ found in this manner is transmitted to the division unit 17. The division unit 17 functions to deconvolve the level $\alpha$ in the convolved region. Thus, by this deconvolution, the masking spectrum can be obtained from the level $\alpha$. That is, this masking spectrum proves to be the allowable noise spectrum found from one band to another. Although deconvolution necessitates a complex processing operation, it is performed with the present embodiment with the use of a simplified division unit 17.

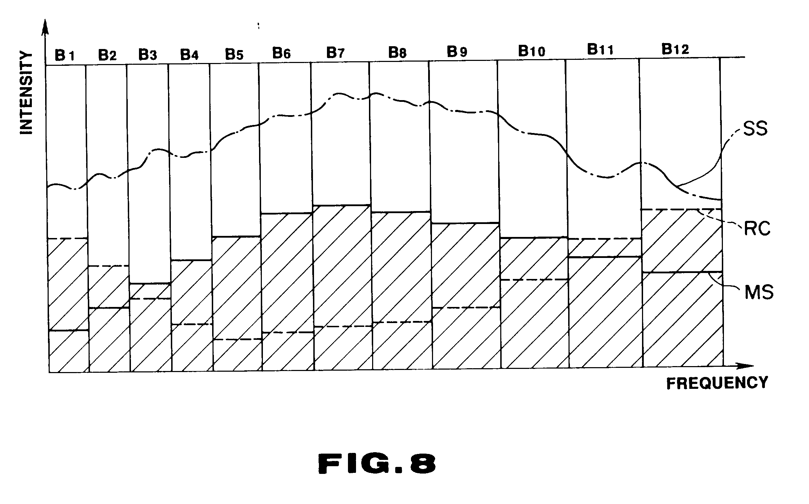

The masking spectrum is transmitted to a subtracter 19 by means of synthesizing circuits 18 and 56. To the subtracter 19, the output of the sum detection circuit 14, that is the bark spectrum SB, is supplied by means of a delay circuit 21. Thus the masking spectrum and the bark spectrum SB are processed by the subtracter 19 by a subtracting operation, whereby, as shown in Figure 7, the bark spectrum SB is masked at lower than the level indicated by the level of the masking spectrum MS.

The output of the subtracter 19 is supplied to the quantization circuit 24 by means of a ROM 20. In the quantization circuit 24, the amplitude Am supplied thereto by means of the delay circuit 23 is quantized with the number of bits conforming to the output from the subtracter 19. In other words, the signal components of each frequency band are quantized with the number of bits allocated in accordance with the level difference between the energy of each critical band and the output of the synthesizing circuit 56 Meanwhile, the delay circuit 21 is provided for delaying the bark spectrum SB from the sum detection circuit 14 in consideration of the delay in each circuit upstream of the synthesizing circuit 56, while the delay circuit 23 is provided for delaying the amplitude Am in consideration of the delay caused in each circuit upstream of the ROM 20. The ROM 20 stores the data of the number of bits allocated for quantization in the quantization circuit 24 and outputs the data of the allocated number of bits conforming to the output of the subtracter 19.

It will be noted that, in the synthesis by the synthesizing circuit 18, the data indicating the so-called minimum audibility curve (equal loudness curve) RC, which represents the characteristics of the human auditory sense, from a minimum audibility curve generating circuit 22, shown in Figure 8 and the masking spectrum MS, are synthesized. By synthesizing the minimum audibility curve RC and the masking spectrum MS in this manner, the allowable noise level may be defined as the upper boundary of an area indicated by the hatched lines in the drawing, so that the number of bits allocated to this area may be diminished. Meanwhile, in Figure 8, the frequency range has been divided into the critical bands shown in Figure 4 and the signal spectrum SS is shown simultaneously.

With the present digital signal encoding apparatus, the allowable noise level is increased and the allocated number of bits decreased towards the higher frequency side with the lesser amount of the energy, while the signal components are quantized with the number of bits which takes into account the masking of the signals on the frequency axis from one band to another, so that the amount of bit reduction may be increased, that is, the bit rate may be decreased.

Also, in the present embodiment, the allocated number of bits for quantization is determined in consideration of the mentioned masking on the frequency axis, while the second allowable noise level of the band under consideration is set on the basis of the energies of the signals temporally adjacent to the band under consideration for quantization. In this manner, the allocated number of bits for quantization which takes into account the temporal masking on the time axis may be determined simultaneously. That is, the second allowable noise level is additionally set for the frequency band under consideration at the current time point, for which the first allowable noise level has been set in the first noise level setting means, so that the temporal masking by signals lying at the temporally adjacent earlier and later points on the time axis may also be taken into account. To this effect, not only the output of the synthesizing circuit 18 but also the output of the synthesizing circuit 55 of the second noise level setting means is supplied to the synthesizing circuit 56,

In this manner, the level of temporal masking based on the energies of the signals lying at the adjacent time points with respect to the signal at the current time point of the band under consideration is computed as the signal of the second allowable noise level and supplied to the synthesizing circuit 55, so that the allowable noise level by these temporally adjacent signals is formed by the synthesizing circuit 55.

For obtaining the second allowable noise level, the present apparatus is provided with the memory 51 for writing/reading the output of the sum detection circuit 14 for every 512 samples, the memory 52 similar to the memory 51, the coefficient multiplication units 53 and 54 and the synthesizing circuit 55. That is, if the time point at which the output of the memory 51 is obtained is the current time point $T_0$, the time point at which the output of the sum detection circuit 14 is supplied to the memory 51 is the later time point $T_{+1}$ which is temporally after the current time point $T_0$ (future time relative to current time point $T_0$), while the time point of outputting from the memory 52 is the earlier time point $T_{-1}$ temporally before the current time point $T_0$ (past time relative to current time $T_0$).

The signal at the later time point $T_{+1}$, that is the output of the sum detection circuit 14, is supplied to the coefficient multiplication unit 53. In the coefficient multiplication unit 53, the signal at the later time point $T_{+1}$ is multiplied by a multiplication coefficient which has been determined in consideration of the temporal masking by the signal of the band under consideration supplied at the later time point $T_{+1}$ to the coefficient multiplication unit 53 on the signal of the band under consideration at the current time point $T_0$ (backward masking). That is, the multiplication coefficient is set in consideration of the effects brought about at the synthesis circuits 55 and 56. If the signal at the later time point $T_{+1}$ is normalized to one, the signal at the later time point $T_{+1}$ is multiplied by a multiplication coefficient $k_B$ corresponding to the level at which the backward masking by the signal at the later time point $T_{+1}$ acts on the signal at the current time point $T_0$. The signal at the earlier time point $T_{-1}$, that is the output from the memory 52, is supplied to the coefficient multiplication unit 54. At the coefficient multiplication unit 54, the signal at the earlier time point $T_{-1}$ is multiplied by a multiplication coefficient determined in consideration of the temporal masking effect of the signal of the band under consideration at the current time point $T_0$ by the signal of the band under consideration supplied at the earlier time point $T_{-1}$ to the coefficient multiplication unit 54 (forward masking). Thus the multiplication coefficient is also determined to take the effect brought about at the synthesizing circuits 55 and 56 into account. If the signal at the earlier time point $T_{-1}$ is normalized, the signal at the earlier time point $T_{-1}$ is multiplied by a multiplication coefficient $k_F$ corresponding to the level at which the forward masking by the signal at the earlier time point $T_{-1}$ acts on the signal at the current time point $T_0$. The output of the coefficient multiplication units 53 and 54 are synthesized in the synthesizing circuit 55 into the above-mentioned second allowable noise level. The synthesizing circuit 55 operates for adding the outputs of the coefficient multiplication units 53 and 54 together. The so-produced output of the synthesizing circuit 55 is supplied to the synthesizing circuit 56.

In the synthesizing circuit 56, the larger one of the outputs of the synthesizing circuit 55 or 18 is selected or, alternatively, the outputs of the circuits 55, 18 are added together after multiplication by predetermined weighting coefficients. The latter synthesizing operation by addition may also be so performed that, in finding the second allowable noise level, the energies of the overall frequency bands are taken into account.

The above described minimum audibility curve synthesizing operation may be omitted in which case the minimum audibility curve generating circuit 22 and the synthesizing circuit 18 shown in Figure 3 may be eliminated. Thus the output of the subtracter 16 may be transmitted directly to the synthesizing circuit 56 after deconvolution by the division circuit 17.

With the above described digital signal encoding apparatus, the first allowable noise level which takes the masking on the frequency axis into account is set by the first noise level setting means for the signals under consideration for quantization, at the same time that the second allowable noise level, which takes the temporal masking by signals temporally adjacent to the signals of the band under consideration into account, is also set by the second noise level setting means for the same signals under consideration for quantization. The number of bits allocated for quantization by the quantization circuit 24 is set from one band to another on the basis of these first and second allowable noise levels, so that the amount of bit reduction may be increased, or conversely, the bit rate may be lowered, without degrading the sound quality.

The present invention may also be applied to a band-dividing and encoding apparatus, shown for example in Figure 9, besides the apparatus for adaptive transform and encoding, shown for example in Figure 3.

Referring to Figure 9, audio signals on the time axis are supplied via input terminal 61 to bandpass filters (BPFs) $62_1$ to $62_3$. The BPF $62_1$ has the frequency range of 0 to 6 kHz of the input audio signals as the passband, the BPF $62_2$ has the frequency range of 6 to 12 kHz of the input audio signals as the passband, and the BPF $62_3$ has the frequency range of 12 to 24 kHz of the input audio signals as the passband. The outputs of these BPFs are transmitted to fast Fourrier transform (FFT) circuits $63_1$ and $63_3$. In the FFT circuit $63_1$, FFT processing is performed for example for every 128 samples, whereas, in the FFT circuits $63_2$ and $63_3$, FFT processing is performed for example for every 64 samples. The outputs of the FFT circuits $63_1$ to $63_3$ are transmitted to quantization circuits $64_1$ to $64_3$, similar to the circuitry downstream of the FFT circuit 11 in Figure 3, so as to be processed similarly to the preceding embodiments. The outputs of the quantization circuits $64_1$ to $64_3$ are synthesized in a synthesizing circuit 65 and outputted at an output terminal 66. With the arrangement shown in Figure 9, it is possible to increase the amount of bit reduction, while minimizing the deterioration in the sound quality, similarly to the apparatus shown in Figure 1.

Figure 10 shows the resolution in the frequency domain and the time domain in the apparatus shown in Figure 9, wherein a unit of processing by band division of fast Fourrier transform is shown and each block is designated by two parameters m and n is b(m,n) where m is the band number and n the time number. It is seen from Figure 8 that, for the lower range of 0 to 6 kHz, each block in each frequency band has a time duration (time resolution) of 10.67 msec, and that, for the mid and higher frequency ranges of 6 to 12 kHz and 12 to 24 kHz, respectively, each block has the time duration of 5.3 msec and the time duration of 2.67 msec, respectively.

## Claims

1. A digital signal encoding apparatus for encoding an input digital signal, the apparatus comprising:

   dividing means (13) supplied with said input digital signal for dividing the frequency range of said input digital signal into a plurality of frequency bands;
   first noise level setting means (14 to 18) for setting a first allowable noise level of each frequency band based on the energy of each frequency band;
   second noise level setting means (51 to 55) for setting a second allowable noise level of each frequency band based on the energies of signals in the temporally adjacent corresponding frequency band;
   combining means (55,56) for combining said first and second allowable noise levels, for generating a combined allowable noise level; and quantizing means (24) for quantizing signal components of each frequency band with a number of bits depending upon said combined allowable noise level.

2. Apparatus according to claim 1 wherein said dividing means (13) divides the frequency range of said input digital signal into a plurality of frequency bands so that the bandwidth of each frequency band is selected to be broader towards the side of frequency bands of higher frequencies.

3. Apparatus according to claim 1 wherein said dividing means (13) includes transform coding means for transform coding a predetermined number of samples of said input digital signal for generating co-efficient data.

4. Apparatus according to claim 3 wherein each of said plurality of frequency bands corresponds to a critical band.

5. Apparatus according to claim 1 wherein said input digital signal is the coefficient data obtained upon orthogonal transform of an audio signal.

6. Apparatus according to claim 1 wherein said input digital signal is the amplitude value information based on the coefficient data obtained upon orthogonal transform of said audio signal.

7. Apparatus according to claim 5 or claim 6 wherein said audio signal to be processed by orthogonal transform is the audio signal divided into predetermined frequency ranges by a band-dividing filter.

8. Apparatus according to any one of claims 1 to 7 wherein said first allowable noise level is found on the basis of the energy of each frequency band on which a predetermined weighting function is convolved.

9. Apparatus according to any one of claims 1 to 7 wherein said first and second allowable noise levels are found on the basis of the masking effect for each frequency band.

10. Apparatus according to any one of claims 1 to 7 wherein said first allowable noise level has been corrected on the basis of an equal loudness curve.

## Patentansprüche

1. Digitales Signalkodiergerät zum Kodieren eines digitalen Eingangssignals, bestehend aus:

   einer mit dem digitalen Eingangssignal beaufschlagten Teileinrichtung (13) zum Teilen des Frequenzbereichs des Eingangssignals in mehrere Frequenzbänder,
   einer ersten Rauschpegel-Einstelleinrichtung (14 bis 18) zum Einstellen eines ersten zulässigen Rauschpegels jedes Frequenzbandes auf der Basis der Energie jedes Frequenzbandes,
   einer zweiten Rauschpegel-Einstelleinrichtung (51 bis 55) zum Einstellen eines zweiten zulässigen Rauschpegels jedes Frequenzbandes auf der Basis der Energie von Signalen in dem zeitmäßig benachbarten korrespondierenden Frequenzband,
   einer Kombiniereinrichtung (55, 56) zum Kombinieren des ersten und zweiten zulässigen Rauschpegels zur Erzeugung eines kombinierten zulässigen Rauschpegels, und
   einer Quantisierungseinrichtung (24) zum Quantisieren von Signalkomponenten jedes Frequenzbandes mit einer vom kombinierten zulässigen Rauschpegel abhängigen Zahl Bits.

2. Gerät nach Anspruch 1, wobei die Teileinrichtung (13) den Frequenzbereich des digitalen Eingangssignals derart in mehrere Frequenzbänder teilt, daß die Bandbreite der Frequenzbänder mit zunehmender Frequenz der Frequenzbänder breiter wird.

3. Gerät nach Anspruch 1, wobei die Teileinrichtung (13) eine Transformationskodiereinrichtung zum Transformationskodieren einer vorbestimmten Zahl Samples des digitalen Eingangssignals zum Erzeugen koeffizienter Daten aufweist.

4. Gerät nach Anspruch 3, wobei die mehreren Frequenzbänder mit einem kritischen Band korrespondieren.

5. Gerät nach Anspruch 1, wobei das digitale Eingangssignal aus den bei einer orthogonalen Transformation eines Audiosignals erhaltenen koeffizienten Daten besteht.

6. Gerät nach Anspruch 1, wobei das digitale Eingangssignal die auf den bei der orthogonalen Transformation des Audiosignals erhaltenen koeffizienten Daten basierenden Amplitudenwertinformation ist.

7. Gerät nach Anspruch 5 oder 6, wobei das durch die orthogonale Transformation zu verarbeitende Audiosignal das durch ein Bandteilungsfilter in vorbestimmte Frequenzbereiche geteilte Audiosignal ist.

8. Gerät nach einem der Ansprüche 1 bis 7, wobei der erste zulässige Rauschpegel auf der Basis der Energie jedes Frequenzbandes, auf dem eine vorbestimmten Gewichtsfunktion konvolviert ist, gefunden wird.

9. Gerät nach einem der Ansprüche 1 bis 7, wobei der erste und zweite zulässige Rauschpegel auf der Basis des Maskierungseffektes für jedes Frequenzband gefunden werden.

10. Gerät nach einem der Ansprüche 1 bis 7, wobei der erste zulässige Rauschpegel auf der Basis einer Kurve gleicher Lautstärke korrigiert worden ist.

## Revendications

1. Dispositif de codage de signaux numériques pour coder un signal numérique d'entrée, le dispositif comprenant:

   - des moyens de division (13) recevant ledit signal numérique d'entrée pour diviser la gamme de fréquences dudit signal numérique d'entrée en une pluralité de bandes de fréquences;
   - des premiers moyens d'établissement de niveau de bruit (14 à 18) pour établir un premier niveau de bruit admissible dans chaque bande de fréquences basé sur l'énergie dans chaque bande de fréquences;
   - des deuxièmes moyens d'établissement de niveau de bruit (51 à 55) pour établir un deuxième niveau de bruit admissible dans chaque bande de fréquences basé sur les énergies des signaux dans la bande de fréquences correspondante temporellement voisine;
   - des moyens de combinaison (55, 56) pour combiner lesdits premier et deuxième niveaux de bruit admissibles pour produire un niveau de bruit admissible combiné; et
   - des moyens de quantification (24) pour quantifier les composantes du signal de chaque bande de fréquences avec un nombre de binaires dépendant dudit niveau de bruit admissible combiné.

2. Dispositif selon la revendication 1, dans lequel lesdits moyens de division (13) divisent la gamme de fréquences dudit signal numérique d'entrée en une pluralité de bandes de fréquences de telle manière que la largeur de bande de chaque bande de fréquences soit sélectionnée pour être plus grande vers le côté des bandes de fréquences à fréquences plus élevées.

3. Dispositif selon la revendication 1, dans lequel lesdits moyens de division (13) comprennent des moyens de codage à transformation pour coder avec transformation un nombre prédéterminé d'échantillons dudit signal numérique d'entrée pour produire des données de coefficient.

4. Dispositif selon la revendication 3, dans lequel chaque bande de ladite pluralité de bandes de fréquences correspond à une bande critique.

5. Dispositif selon la revendication 1, dans lequel ledit signal numérique d'entrée est les données de coefficient obtenues lors de la transformation orthogonale d'un signal audio.

6. Dispositif selon la revendication 1, dans lequel ledit signal numérique d'entrée est l'information de la valeur d'amplitude basée sur les données de coefficient obtenues lors de la transformation orthogonale dudit signal audio.

7. Dispositif selon la revendication 5 ou la revendication 6, dans lequel ledit signal audio à traiter par une transformation orthogonale est le signal audio divisé en des bandes prédéterminées de fréquences par un filtre de division en bandes.

8. Dispositif selon l'une quelconque des revendications 1 à 7, dans lequel ledit premier niveau de bruit admissible est trouvé sur la base de l'énergie dans chaque bande de fréquences à laquelle une fonction de pondération prédéterminée est appliquée par convolution.

9. Dispositif selon l'une quelconque des revendications 1 à 7, dans lequel lesdits premier et deuxième niveaux de bruit admissibles sont trouvés sur la base de l'effet de masquage pour chaque bande de fréquences.

10. Dispositif selon l'une quelconque des revendications 1 à 7, dans lequel ledit premier niveau de bruit admissible a été corrigé sur la base d'une courbe d'isosonie.

**FIG.1**

**FIG.2**

**FIG.3**

EP 0 458 645 B1

EP 0 458 645 B1

**FIG.4**

**FIG.5**

**FIG.7**

12

**FIG.6**

13

FIG.8

**FIG.9**

**FIG.10**